# EUROPEAN PATENT APPLICATION

(11) **EP 3 070 841 A1**
(43) Date of publication of application: **21.09.2016**
(21) Application number: 15305408.5
(22) Date of filing: 20.03.2015
(51) Int. Cl.: H03F 3/191, H03F 13/00, H03C 1/46, H03C 3/42, H03H 9/54

(54) **APPARATUS, TRANSMITTER, METHOD AND COMPUTER PROGRAM SUITABLE FOR CONTROLLING A CONTRIBUTION OF A FIRST PLURALITY OF CONTINUOUSLY OSCILLATING NANO-MECHANICAL OSCILLATOR MODULES TO A COMPOSITE SIGNAL**

(71) Applicant: ALCATEL LUCENT, 92100 Boulogne-Billancourt (FR)
(72) Inventor: Dr. Templ, Wolfgang, 70435 Stuttgart (DE); Wiegner, Dirk, 70435 Stuttgart (DE)
(74) Representative: 2SPL Patentanwälte PartG mbB

(57) **Abstract**

Embodiments relate to an apparatus (10), a transmitter (300), a method and a computer program suitable for controlling a contribution of a first plurality of continuously oscillating nano-mechanical oscillator modules (100a; 100b) to a composite signal (50). The apparatus (10) comprises at least one interface (12) to transmit a control signal and to obtain information related to a plurality of frequency components of the composite signal. The apparatus (10) further comprises a control module (14) to determine the control signal based on the information related to the plurality of frequency components. The control signal controls the contribution of the first plurality (100a; 100b) to the composite signal (50).

## Description

### Technical Field

Embodiments relate to an apparatus, a transmitter, a method and a computer program suitable for controlling a contribution of a first plurality of continuously oscillating nano-mechanical oscillator modules to a composite signal, more particularly, but not exclusively, based on information related to a plurality of frequency components of the composite signal.

### Background

This section introduces aspects that may be helpful in facilitating a better understanding of the invention. Accordingly, the statements of this section are to be read in this light and are not to be understood as admissions about what is in the prior art or what is not in the prior art.

Energy efficiency, linearity and flexibility are determining factors and competitive parameters of mobile radio transmitters. Some known transmitter concepts use a disruptive transmitter architecture, which is based on analogue signal creation. For example, arrays of nano-mechanical resonators are used. Some nano-mechanical resonators use reeds or cantilevers, which are designed to oscillate at frequencies, which are, for example, determined by the geometric design, the material, the medium around the respective reed, etc.

Conventional and probably future wireless communication makes use of modulation formats and advanced transmission technologies, which may need high quality signal amplification. For example, transmit signals use high peak-to-average ratios. Especially power amplifiers, which are used for wireless communication, are a contributor to the overall energy consumption in such communication systems. Resonators, such as nano-mechanical resonators, are used in such power amplifiers to compose a transmit signal, where resonators generate component signals for sub-bands or frequency bins, which are combined to compose the overall transmit signal. More details on amplifiers, digital/analog converters, and/or baseband to radio frequency converters using mechanical resonators can, for example, be found in European Patent Application EP 2 509 217 A1. To some of the concepts used for these amplifiers or transmitters it is also referred to as HARP, as the concept has similarities to the musical harp instrument.

### Summary of illustrative Embodiments

Some simplifications may be made in the following summary, which is intended to highlight and introduce some aspects of the various exemplary embodiments, but such simplifications are not intended to limit the scope of the invention(s). Detailed descriptions of a preferred exemplary embodiment adequate to allow those of ordinary skill in the art to make and use the inventive concepts will follow in later sections.

Embodiments provide an apparatus, a transmitter, a method and a computer program suitable for controlling a contribution of a first plurality of continuously oscillating nano-mechanical oscillator modules to a composite signal. Embodiments are based on the finding, that instead of attenuating the nano-mechanical oscillator modules, embodiments may switch the voltage on the supply voltage feed to control the contribution of the module to the signal, while the resonators may oscillate continuously. At least some embodiments may also be based on a finding, that, depending on the required power, in addition to one or more base nano-mechanical oscillator modules oscillating continuously, additional nano-mechanical oscillator modules may be activated to reach a higher power output, which may decrease base power consumption.

Embodiments provide an apparatus suitable for controlling a contribution of a first plurality of continuously oscillating nano-mechanical oscillator modules to a composite signal. The apparatus comprises at least one interface to transmit a control signal and to obtain information related to a plurality of frequency components of the composite signal. The apparatus further comprises a control module to determine the control signal based on the information related to the plurality of frequency components. The control signal controls the contribution of the first plurality to the composite signal. Using the first plurality of continuously oscillating nano-mechanical oscillator modules and controlling their contribution to the composite signal may enable instantaneous changes in the composite signal, and may offer a lower complexity compared to attenuating and exciting the nano-mechanical oscillator modules.

In at least some embodiments, the control module may be configured to control a plurality of switches between a plurality of resonator outputs of the first plurality and a shared power supply. Using switches between a shared power supply and the resonator outputs for controlling the contribution of the oscillators to the composite signal may enable an efficient layout and may keep the amount and complexity of the required components low.

In at least some embodiments, the control module may be configured to control a plurality of power supplies for a plurality of resonator outputs of the first plurality. Using individual power supplies for the resonator outputs for controlling the contribution of the oscillators to the composite signal may provide flexibility during implementation and may offer additional degrees of freedom for the power supply of the resonator outputs, e.g. variable supply voltages, which may enable power adjustments per resonator element based on the supply voltage. Varying the supply voltage of a resonator element may enable additional means for power adjustments, for example fine-tuning of a power contribution per resonator element may be carried out, and may enable reductions of the power consumption of the oscillators.

In at least some embodiments, the apparatus may further comprise the first plurality. A nano-mechanical oscillator module of the first plurality may be configured to generate radio frequency signals at a specified oscillator frequency. Having a specified frequency for a nano-mechanical oscillator module may enable the oscillators to be grouped to output a higher aggregate power. Using multiple oscillators, each with a specified frequency, e.g. based on the sub-carrier frequencies used in a composite signal, may enable a composition of different (carrier) frequencies, e.g. the carrier frequencies in an LTE multi-carrier signal.

In at least some embodiments, the apparatus may further comprise a second plurality of nano-mechanical oscillator modules. The apparatus may be further configured to control a contribution of the second plurality to the composite signal. The control module may be further configured to control the contribution of the second plurality to the composite signal via the control signal. Having the second plurality of nano-mechanical oscillator modules, which might not be oscillating continuously, may provide an adjustable power output for different load situations.

In at least some embodiments, a nano-mechanical oscillator module of the second plurality may be configured to generate radio frequency signals at a specified oscillator frequency. Having a specified frequency for a nano-mechanical oscillator may enable the oscillators to be grouped to output a higher aggregate power. Using multiple oscillators, each with a specified frequency, e.g. based on the sub-carrier frequencies used in a composite signal, may enable a composition of different (carrier) frequencies, e.g. the carrier frequencies in an LTE multi-carrier signal.

In at least some embodiments, the apparatus may further comprise a third plurality of subsets of nano-mechanical oscillator modules. A subset may comprise one or more nano-mechanical oscillator modules generating radio frequency signals at the specified oscillator frequency. Having a subset of oscillators of the same specified oscillator frequency may enable the oscillators to be grouped to output a higher aggregate power compared to a single oscillator.

In at least some embodiments, a subset of the third plurality may comprise at least one continuously oscillating nano-mechanical oscillator module of the first plurality. Having continuously oscillating nano-mechanical oscillators in a subset may enable an instantaneous availability of a frequency component for the composite signal, which may be added to a signal at anytime, e.g. using a switch, and might not require a build-up time before contribution, as it is oscillating continuously.

In at least some embodiments, a subset of the third plurality may further comprise at least one nano-mechanical oscillator module of the second plurality. Having nano-mechanical oscillators in a subset that may be activated/deactivated based on a power requirement may enable energy savings in low power scenarios.

In at least some embodiments the at least one interface may be further configured to obtain information related to a power for the composite signal. The control module may be further configured to determine the control signal based on the information related to the power. Determining the control signal based on the information to the power may enable energy savings in low power scenarios.

In at least some embodiments, the control module may be further configured to control an activation and/or deactivation of an excitation of the nano-mechanical oscillator modules of the second plurality. The control module may be further configured to determine the control signal based on the information related to the power such that the excitation of the nano-mechanical oscillator modules of the second plurality is activated and/or deactivated based on the information related to the power. Activating/Deactivating nano-mechanical oscillator modules of the second plurality based on the information related to the power may enable energy savings in low power scenarios.

Embodiments further provide a transmitter comprising the apparatus suitable for controlling a contribution of a first plurality of continuously oscillating nano-mechanical oscillator modules to a composite signal, and the first plurality of continuously oscillating nano-mechanical oscillator modules. The composite signal is provided to an antenna connector. A transmitter comprising the apparatus and the first plurality of continuously oscillating nano-mechanical oscillator modules, wherein the apparatus may control the contribution of the continuously oscillating nano-mechanical oscillator modules to the composite signal, may enable instantaneous changes in the composite signal, may offer a lower complexity compared to attenuating and exciting the nano-mechanical oscillator modules, may offer an improved linearity and might not require additional amplifiers for amplifying the composite signal.

In at least some embodiments, the transmitter may further comprises the second plurality of nano-mechanical oscillator modules and the third plurality of subsets as described above. A transmitter comprising nano-mechanical oscillators in a subset that may be activated/deactivated based on a power requirement may enable energy savings in low power scenarios.

Embodiments further provide a method suitable for controlling a contribution of a first plurality of continuously oscillating nano-mechanical oscillator modules to a composite signal. The method comprises transmitting a control signal, obtaining information related to a plurality of frequency components of the composite signal and determining the control signal based on the information related to the plurality of frequency components. The control signal controls the contribution of the first plurality to the composite signal.

Embodiments further provide a computer program having a program code for performing at least one of the above methods, when the computer program is executed on a computer, a processor, or a programmable hardware component. A further embodiment is a computer readable storage medium storing instructions which, when executed by a computer, processor, or programmable hardware component, cause the computer to implement one of the methods described herein.

### Brief description of the figures

Some other features or aspects will be described using the following non-limiting embodiments of apparatuses or methods or computer programs or computer program products by way of example only, and with reference to the accompanying figures, in which:
Fig. 1 illustrates a block diagram of an embodiment of an apparatus suitable for controlling a contribution of a first plurality of continuously oscillating nano-mechanical oscillator modules to a composite signal;
Fig. 2 illustrates a block diagram of a HARP concept based on reed-based nano-mechanical oscillator modules;
Fig. 3a illustrates a block diagram of an embodiment of the apparatus controlling a plurality of switches between a plurality of resonator outputs of the first plurality and a shared power supply in a transmitter concept;
Fig. 3b illustrates a block diagram of an embodiment of the apparatus controlling a plurality of power supplies for a plurality of resonator outputs of the first plurality and a shared power supply in a transmitter concept;
Fig. 4 illustrates a block diagram of an embodiment of the apparatus comprising the first plurality, the second plurality and the third plurality;
Fig. 5 illustrates a block diagram of an embodiment of the apparatus comprising the first plurality of continuously oscillating nano-mechanical oscillator modules, the second plurality of nano-mechanical oscillator module and the third plurality of subsets;
Fig. 6a illustrates a block diagram of an embodiment of a transmitter module comprising the apparatus and the first plurality of continuously oscillating nano-mechanical oscillator modules;
Fig. 6b illustrates a block diagram of an embodiment of the transmitter module comprising the apparatus, the first plurality of continuously oscillating nano-mechanical oscillator modules, the second plurality of nano-mechanical oscillator module and the third plurality of subsets; and
Fig. 7 illustrates a block diagram of an embodiment of a method for suitable controlling a contribution of a first plurality of continuously oscillating nano-mechanical oscillator modules to a composite signal.

### Description of Embodiments

Various example embodiments will now be described more fully with reference to the accompanying drawings in which some example embodiments are illustrated. In the figures, the thicknesses of lines, layers or regions may be exaggerated for clarity. Optional components are illustrated using broken, dashed or dotted lines.

Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the figures.

As used herein, the term, "or" refers to a non-exclusive or, unless otherwise indicated (e.g., "or else" or "or in the alternative"). Furthermore, as used herein, words used to describe a relationship between elements should be broadly construed to include a direct relationship or the presence of intervening elements unless otherwise indicated. For example, when an element is referred to as being "connected" or "coupled" to another element, the element may be directly connected or coupled to the other element or intervening elements may be present. In contrast, when an element is referred to as being "directly connected" or "directly coupled" to another element, there are no intervening elements present. Similarly, words such as "between", "adjacent", and the like should be interpreted in a like fashion.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" or "including," when used herein, specify the presence of stated features, integers, steps, operations, elements or components, but do not preclude the presence or addition of one or more other features, integers, steps, operations, elements, components or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

A novel concept in transmitter design is the HARP transmitter concept, which is based on a reed resonator, to be used as a spectral radio frequency amplifier. The HARP transmitter concept addresses future compact and energy efficient transmitters. Very roughly, HARP is based on the idea to compose a radio frequency signal, e.g. an LTE signal, by digital excitation of dedicated nano-mechanical resonators, which themselves generate the spectral components of the LTE signal to be transmitted, rather than generating the signal by the conventional lineup of digital/analog conversion, modulation/up-conversion and amplification. In LTE, not all spectral components might be required all the time, which means to very quickly attenuate resonators, which at a specific point in time must not contribute to the LTE signal. Such time-constrained attenuation and later time-constrained excitation of the resonators may reveal to be difficult to achieve. Conventional solutions may try to attenuate the resonators, either mechanically, electro-static or by piezo. Embodiments may provide an approach to circumvent the issue.

The basic idea of at least some embodiments might not be to attenuate and later again activate the nano-mechanical resonators generating the spectral signal components in the HARP concept, but may be to keep the resonators permanently oscillating and to switch on-/off either the respective supply voltage feed (e.g. in case of one common supply) of the resonators or to switch on-/off the respective voltage supplies in case of dedicated voltages supplies. Alternatively resonator signals might be gated.

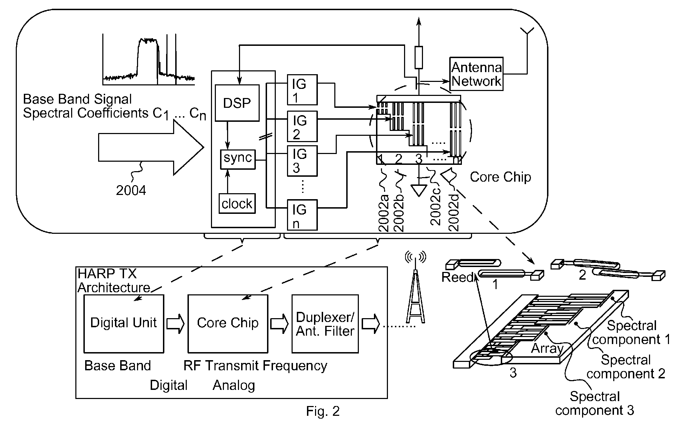

The core component of the HARP transmitter may, for example, be an array of nano-mechanical oscillators, which may feature an ultrahigh quality factor. Fig. 2 shows this basic principle. The resonators may be grouped in sub-arrays 2002a-d, each sub-array representing one spectral component of the signal to be transmitted 2004. Each sub-array may be excited using an impulse generator IG1-4, which may be controlled by a DSP whose output is synchronized with a clocking signal. The DSP, synchronization module and clock may be comprised in a Digital Unit, while the Impulse Generators IG1-4 and the sub-arrays may be comprised in a core chip. Depending on whether the specific spectral components are required to contribute to the signal to be transmitted at a point in time, they may be activated (means they oscillate) or oscillation may be stopped. Since a rapid stopping of the resonators and thus oscillations may be difficult to achieve, embodiments may keep all resonators/sub-arrays permanently oscillating and instead of stopping the oscillation to introduce switches or switchable supplies, which may allow to turn-off the contribution of the respective resonators/sub-arrays to the signal to be transmitted.

Embodiments continuously keeping all resonators/sub-arrays of the HARP array oscillating and instead of attenuating resonator sub-arrays, if their spectral contribution is currently not required/allowed, using switches in order to provide spectral contribution of respective resonator arrays, if required, may be preferred in case of full load situation, but at light load situation (e.g. during night times), a continuous excitation of resonators/sub-arrays, which spectral contribution is not required for a longer duration, may have a disadvantageous effect on power consumption, and may be addressed by further embodiments.

At least some embodiments may split the respective sub-arrays of resonators per spectral contribution into additional sub-sub-arrays, which may allow keeping some of the sub-sub-arrays continuously oscillating, while other sub-sub-arrays can be attenuated/turned-off, if required by current load situation. The attenuated resonators/sub-sub-arrays can later be activated with sufficient advance.

In case of full load situation, in embodiments, all resonators/sub-sub-arrays may be continuously oscillating, and their respective spectral contribution may be connected to the output network, if required. In case of longer lasting light load situations, an adequate number of sub-sub-arrays may be attenuated/turned-off, while a for the required output power required number of sub-sub-arrays may be kept in continuous operation and connected to the output network. In at least some embodiments, the power consumption at light load situation may be reduced, since excitation energy for currently not required sub-sub-arrays may be saved. If later higher load situation required higher output power, sufficient number of sub-sub-arrays may be again activated in continuous oscillation.

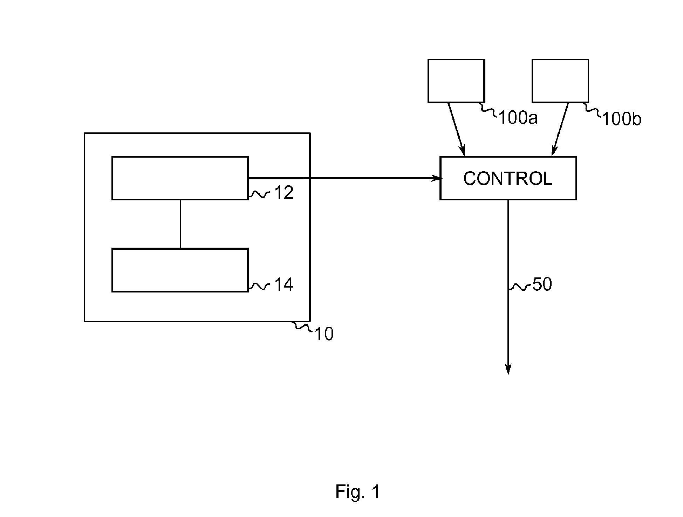

Fig. 1 illustrates a block diagram of an embodiment of an apparatus 10 suitable for controlling a contribution of a first plurality of continuously oscillating nano-mechanical oscillator modules 100a; 100b to a composite signal 50. The apparatus 10 comprises at least one interface 12 and a control module 14, which is coupled to the at least one interface 12.

In at least some embodiments, a nano-mechanical oscillator module may correspond to a nano-mechanical reed/cantilever oscillator (e.g. a HARP oscillator), a nano-mechanical bridge-over-gap oscillator, a cavity-based nano-mechanical oscillator and/or a nano-mechanical oscillator based on a nano-mechanical spherical or disk resonator. In at least some embodiments, a nano-mechanical oscillator module may correspond to an array of such oscillators providing a common output. In at least some embodiments, nano-mechanical oscillator modules of the first plurality of continuously oscillating nano-mechanical oscillator module 100a; 100b may be oscillating continuously during operation of the apparatus 10, e.g. during an operating time of a base station transceiver comprising the apparatus 10. In at least some embodiments, the composite signal 50 may comprise frequency components of a plurality of frequencies, which may correspond to carrier frequencies in a signal, e.g. a Long Term Evolution (LTE) signal. In at least some embodiments, the composite signal 50 may be fed to an antenna connector and/or module, and it may be filtered and/or amplified before transmission. In at least some embodiments, the composite signal 50 may comprise modulated signals on a plurality of carrier frequencies based on a plurality of modulated signals exciting the nano-mechanical oscillator modules.

The apparatus 10 comprises the at least one interface 12 to transmit a control signal and to obtain information related to a plurality of frequency components of the composite signal; The at least one interface 12 may correspond to one or more inputs and/or outputs for receiving and/or transmitting information, which may be in digital (bit) values according to a specified code, within a module, between modules or between modules of different entities. In at least some embodiments, the information related to the plurality of frequency components may comprise information related to whether a frequency component is required for the composite signal 50 at a specific time, which may correspond to whether a subcarrier is being required at that specific point it time. In at least some embodiments, the information related to the plurality of frequency components may correspond to a bit vector indicating whether a frequency component contributes to the composite signal 50. In at least some embodiments, the information related to the plurality of frequency components may comprise information related to a required power for frequency components of the plurality of frequency components and/or information related to supply voltages for frequency components of the plurality of frequency components. Based on the information related to the required power the number of contributing nano-mechanical resonator modules per sub-array may be selected. Based on the information related to the supply voltages, the supply voltages of the selected nano-mechanical oscillator modules may be used to fine-tune the power output.

The apparatus 10 further comprises a control module 14 to determine the control signal based on the information related to the plurality of frequency components. The control signal controls the contribution of the first plurality 100a; 100b to the composite signal 50. In at least some embodiments, the information related to the plurality of frequency components may correspond to a group of binary values indicating whether a frequency component is required for the composite signal 50, which may be used to control a contribution of the frequency component to the composite signal 50. In an alternative embodiment, the information related to the plurality of frequency components may further comprise information related to a required power for the frequency component and/or information related to supply voltages for frequency components of the plurality of frequency components.

In embodiments the control module 14 may be implemented using one or more processing units, one or more processing devices, any means for processing, such as a processor, a computer or a programmable hardware component being operable with accordingly adapted software. In other words, the described functions of the control module 14 may as well be implemented in software, which is then executed on one or more programmable hardware components. Such hardware components may comprise a general purpose processor, a Digital Signal Processor (DSP), a micro-controller, etc.

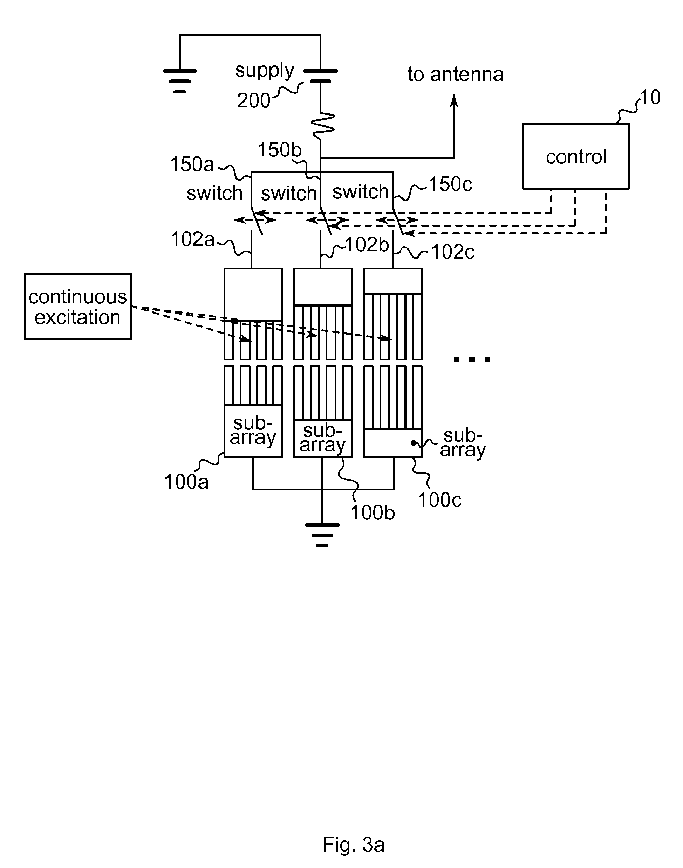

Fig. 3a illustrates a block diagram of an embodiment of the apparatus 10 in a transmitter concept, wherein the control module 14 is configured to control a plurality of switches 150a; 150b; 150c between a plurality of resonator outputs 102a; 102b; 102c of the first plurality 100a; 100b further comprising a continuously oscillating nano-mechanical oscillator module 100c and a shared power supply 200. In at least some embodiments, the plurality of switches 150a; 150b; 150c may correspond to a plurality of semiconductor switches. In an alternative implementation, the plurality of switches may correspond to one or more multiplexers. In at least some embodiments, a voltage applied to the resonator outputs 102a; 102b; 102c may enable a contribution of the nano-mechanical oscillator module to the composite signal 50. In at least some embodiments, the resonator outputs 102a; 102a; 102c may be coupled to an antenna module which may be configured to transmit the composite signal 50. In at least some embodiments, the control module 14 may be configured to control the switches of the plurality of switches 150a; 150b; 150c individually, by group based on the frequency component of the nano-mechanical oscillator modules connected to the switches, and/or by group based on the frequency component and a power requirement. In at least some embodiments, a plurality (or array) of continuously oscillating nano-mechanical oscillator modules may be connected to a common switch, e.g. a plurality of continuously oscillating nano-mechanical oscillator modules generating the same specific oscillator frequency.

Fig. 3a shows three sub-arrays 100a; 100b; 100c with nano-mechanical cantilever resonators, connected to a common power supply 200, each with an interconnected switch (e.g. transistor, MEMS, etc.), allowing to control the contribution of the resonators/sub-arrays separately by turning on or off the respective switches. A control, which may have information about whether a respective spectral component is required at a specific time instance, which may correspond to the information related to a plurality of frequency components of the composite signal, may control the switches 150a; 150b; 150c, and may turn off the voltage supply to the respective resonator outputs, if the respective spectral component is currently not needed in the signal to be transmitted. All resonators may be oscillating permanently. The contribution of the dedicated resonators/sub-arrays to the transmission signal may be controlled by the switches in the DC feeding lines.

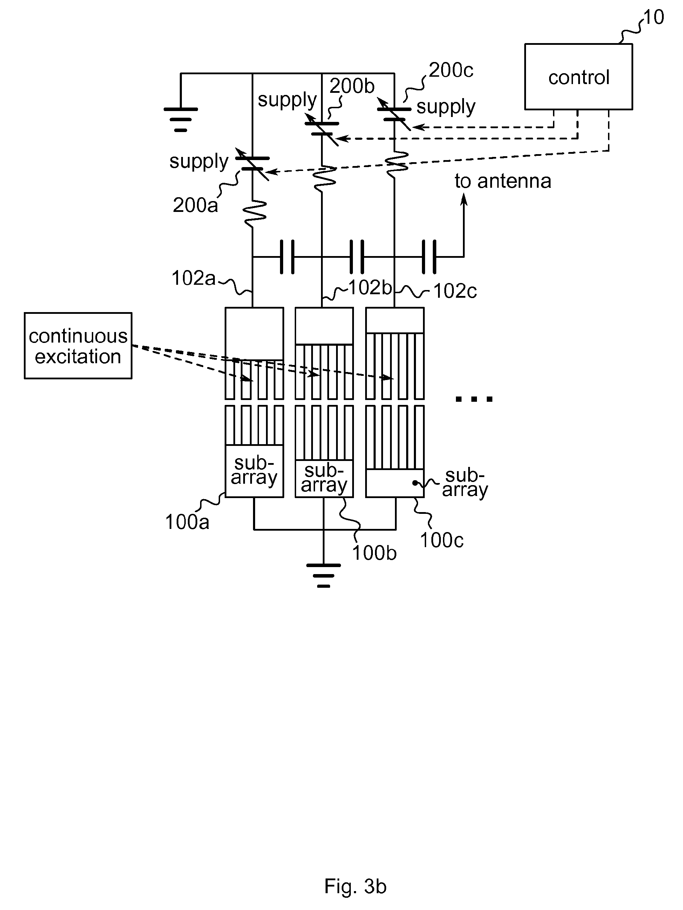

Fig. 3b illustrates a block diagram of an embodiment of the apparatus 10, wherein the control module 14 is configured to control a plurality of power supplies 200a; 200b for a plurality of resonator outputs 102a; 102b; 102c of the first plurality 100a; 100b further comprising the continuously oscillating nano-mechanical oscillator module 100c. In at least some embodiments, a voltage applied to the resonator outputs 102a; 102b; 102c may enable a contribution of the nano-mechanical oscillator module to the composite signal 50. In at least some embodiments, the control module 14 may be configured to control the power supplies 200a; 200b; 200c individually, by group based on the frequency component of the nano-mechanical oscillator modules connected to the switches, and/or by group based on the frequency component and a power requirement. In at least some embodiments, a plurality (or array) of continuously oscillating nano-mechanical oscillator modules may be connected to a common power supply, e.g. a plurality of continuously oscillating nano-mechanical oscillator modules generating the same specific oscillator frequency.

Fig. 3b shows another possible exemplarily embodiment for controlling a contribution of resonators/sub-arrays. Contrary to Fig. 3a, each sub-array may have a dedicated controllable power supply 200a; 200b; 200c or converter, which may allow turning on or -off the supply voltage for the resonator outputs of each sub-array. The dedicated power supplies or converters may be controlled by a central control, which may correspond to the apparatus 10, which has information about whether the respective sub-arrays - and thus spectral RF components - currently have to contribute to the transmit signal or not (e.g. the information related to a plurality of frequency components of the composite signal). All resonators may oscillate permanently. The contribution to the transmit signal may be controlled by the off-switchable power supplies.

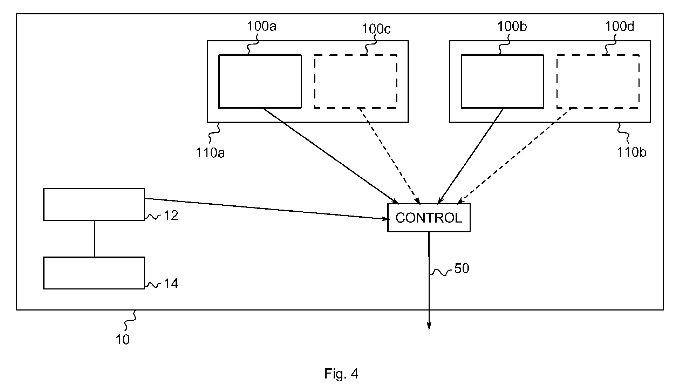

Fig. 4 illustrates a block diagram of an embodiment of the apparatus comprising the first plurality, a second plurality of nano-mechanical oscillator modules 100c; 100d and a third plurality of subsets of nano-mechanical oscillator modules 110a; 110b. As shown in Fig. 4 , in at least some embodiments, the apparatus 10 may further comprise the first plurality 100a; 100b. A nano-mechanical oscillator module of the first plurality 100a; 100b may be configured to generate radio frequency signals at a specified oscillator frequency. In at least some embodiments, the apparatus 10 may further comprise the second plurality of nano-mechanical oscillator modules 100c; 100d. The apparatus 10 may be further configured to control a contribution of the second plurality 100c; 100d to the composite signal 50. The control module 14 may be further configured to control the contribution of the second plurality 100c; 100d to the composite signal 50 via the control signal.

In at least some embodiments, a nano-mechanical oscillator module of the second plurality 100c; 100d may be configured to generate radio frequency signals at a specified oscillator frequency. In at least some embodiments, a nano-mechanical oscillator module may be tuned to the specified oscillator frequency. In at least some embodiments, the specified oscillator frequency may be mapped to physical properties of the nano-mechanical oscillator module, e.g. the length of the reeds of a reed-based nano-mechanical oscillator module.

The second plurality of nano-mechanical oscillator modules 100c; 100d may generate signals at the same frequencies as the first plurality of continuously oscillating nano-mechanical oscillator modules 100a; 100b. The signals of the second plurality of nano-mechanical oscillator modules 100c; 100d may complement the signals of the first plurality of continuously oscillating nano-mechanical oscillator modules 100a; 100b, wherein the nano-mechanical oscillator modules of the second plurality may be activated/deactivated accordingly.

Fig. 4 illustrates a block diagram of an embodiment of the apparatus 10 comprising the at least one interface 12, the control module 14, which is coupled to the at least one interface 12, and further comprising the third plurality of subsets of nano-mechanical oscillator modules 110a; 110b. A subset may comprise one or more nano-mechanical oscillator modules generating radio frequency signals at the specified oscillator frequency. In Fig. 4, the subset 110a may comprise the nano-mechanical oscillator modules 100a; 100c, as described in the above figures, and the subset 110b may comprise the nano-mechanical oscillator modules 100b and 100d as described in the above figures.

In at least some embodiments, a subset of the third plurality 110a; 110b may comprises at least one continuously oscillating nano-mechanical oscillator module of the first plurality 100a; 100b. A subset of the third plurality may further comprise at least one nano-mechanical oscillator module of the second plurality 100c; 100d.

In at least some embodiments, the at least one interface 12 may be further configured to obtain information related to a power for the composite signal 50. The control module 14 may be further configured to determine the control signal based on the information related to the power.

In at least some embodiments, the control module 14 may be further configured to control an activation and/or deactivation of an excitation of the nano-mechanical oscillator modules of the second plurality 100c; 100d. The control module 14 may be further configured to determine the control signal based on the information related to the power such that the excitation of the nano-mechanical oscillator modules of the second plurality 100c; 100d is activated and/or deactivated based on the information related to the power. In at least some embodiments, the continuously oscillating nano-mechanical oscillator module of the first plurality 100a; 100b may oscillate continuously, and the control module 14 may control their contribution to the composite signal 50 based on the information related to the plurality of frequency components. For nano-mechanical oscillator module of the second plurality 100c; 100d, the control module 14 may control their activation/deactivation based on the information related to the power, and may further control their contribution to the composite signal 50 based on the information related to the plurality of frequency components, saving energy while nano-mechanical oscillator modules of the second plurality are deactivated. In at least some embodiments, an activation of nano-mechanical oscillator modules of the second plurality 100c; 100d may be started based on a lead time of the nano-mechanical oscillator modules, before an expected rise of a power requirement. In at least some embodiments, a lead time may correspond to a time frame between one period of the oscillator up to a few seconds, to allow building up the nano-mechanical oscillator modules and reaching peak output and stability.

In at least some embodiments, the information related to the power may comprise information related to a desired power output and/or a load for the composite signal. In at least some embodiments, the information related to the desired power output may be linear for a range of frequencies, or the information related to the desired power output may be individual for individual frequencies.

In at least some embodiments, the information related to the power may comprise information related to a required power and the control module 14 may control the activation/deactivation for individual nano-mechanical oscillator modules, for subsets of the third plurality 110a; 110b, for the composite signal 50, or for a fourth plurality of subsets comprising nano-mechanical oscillator modules of the second plurality 100c; 100d, which may be activated/deactivated as a subset for a levelled activation/deactivation of transmission power. In at least some embodiments, a subset of the third plurality 110a; 110b may comprise between a few nano-mechanical oscillator modules up to hundred thousands of nano-mechanical oscillator modules, depending on a required power and/or amplification of the composite signal 50 and depending on the output of single nano-mechanical oscillator modules.

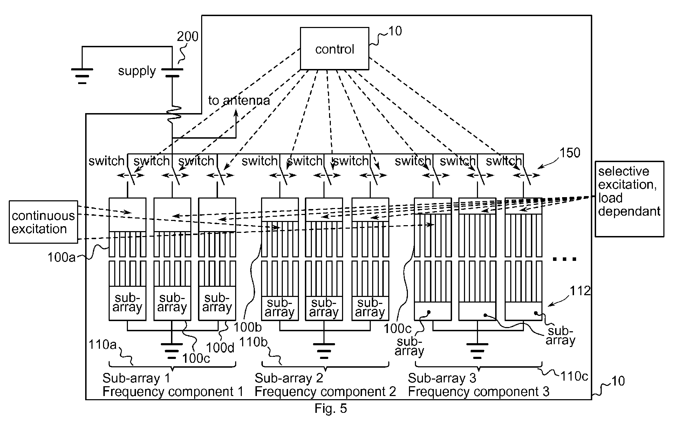

Embodiments may split the frequency specific sub-arrays 110a; 110b; 110c in additional sub-sub-arrays 112, which allows keeping some of the sub-sub-arrays continuously oscillating and some of the sub-sub-arrays to attenuate/turn-off, depending on demand of the current load situation. Compared to connecting or disconnecting the continuously oscillating resonators/sub-arrays to the output network e.g. via switches, this load dependent oscillation activation and deactivation may be seen as a slower overlaying procedure. Figure 5 shows an exemplarily embodiment of the idea proposed here. A split in sub-sub-arrays has been introduced. The sub-sub-arrays may be controlled by a higher control instance, e.g. the control module 14 of the apparatus 10, which may decide if the sub-sub-arrays may be activated or deactivated, depending on the current load situation, e.g. the information related to the power. Especially in case of increasing load, a sufficient advance in time may be provided. In case of activating sub-sub-arrays, the respective sub-sub-arrays might be connected to the output network via switches not before full oscillation has been reached. On the other hand, before sub-sub-arrays are deactivated, they may be disconnected from the output network via the respective switches 150. At least some embodiments may prevent adverse effect on signal quality by intermediate oscillation states. In order to reduce effort, embodiments may control sub-sub-arrays of each sub-array commonly by one control input, instead of controlling all sub-sub-arrays of all sub-arrays independently from each other.

In an exemplary embodiment, three sub-arrays 110a; 110b; 110c, which may correspond to the third plurality of subsets, of HARP may be assumed, wherein each sub-array may represent one spectral component of a transmit signal. In addition, the sub-arrays may be split into additional three sub-sub-arrays, each. Depending if the respective spectral contribution of a sub-array is required, the respective sub-sub-array may be connected to the output network via a respective switch 150. In order to react on different load scenarios, one sub-sub-array of each sub-arrays, e.g. nano-mechanical oscillator module 100a; 100b; 100c of the first plurality 100a; 10b further comprising the continuously oscillating nano-mechanical oscillator module 100c may be connected to a common control, resulting in three control lines, each control line controlling three sub-sub-arrays (one sub-sub-array of each sub-array). In an alternative implementation, each sub-sub-array may be connected to a separate control line to control a more precise power output per sub-array and a sub-array may be connected to a per-sub-array control line controlling a contribution of the spectral component to the signal. In at least some embodiments, one group of three sub-sub-arrays, e.g. the nano-mechanical oscillator modules of the first plurality, may oscillate continuously and thus represent the lowest transmit power level (light-load situation). In case of medium power, the resonators in the second sub-sub-array group, e.g. nano-mechanical oscillator modules of the second plurality 100c; 100d, may be awaked, activated to oscillate and connected to the output network, if the respective spectral component is required. In case of full load, the third group of sub-sub-arrays, e.g. nano-mechanical oscillator modules of the second plurality, may be activated and the respective sub-sub-arrays may be connected to the output network, if their spectral and power contribution is needed. Thus in case of full load, all nine sub-sub-arrays of our example may oscillate and may be connected, if their contribution in required. In case of light load, only three sub-sub-arrays in our example may oscillate and contribute to the output signal if required, all others might be deactivated (not oscillating). In at least some embodiments, the power consumption necessary for excitation of the resonators/sub-sub-arrays may be controlled, depending on load situation.

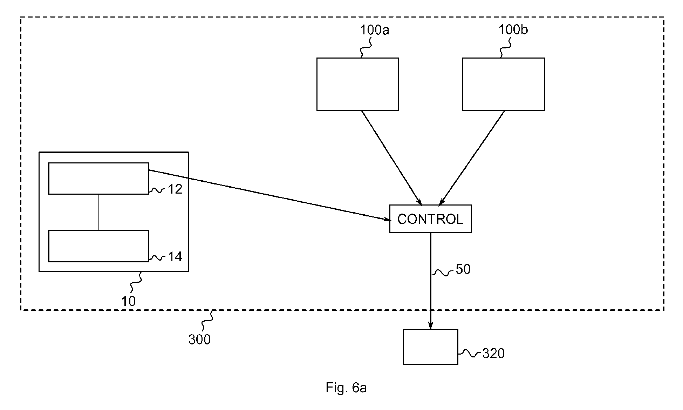

Fig. 6a illustrates a block diagram of an embodiment of a transmitter 300 comprising the apparatus 10 suitable for controlling a contribution of a first plurality of continuously oscillating nano-mechanical oscillator modules 100a; 100b to a composite signal 50, and the first plurality of continuously oscillating nano-mechanical oscillator modules 100a; 100b, wherein the composite signal 50 is provided to an antenna connector 320. The at least one interface 12 is coupled to the control module 14 of the apparatus 10 and the composite signal is coupled to the antenna connector 320. In at least some embodiments, the composite signal 50 may be further filtered and/or amplified further for the antenna connector 320.

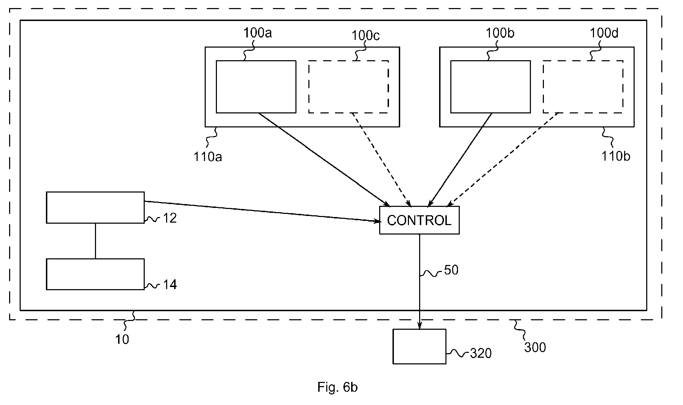

Fig. 6b illustrates a block diagram of an embodiment of the transmitter 300 further comprising the second plurality 100c; 100d and the third plurality 110a; 110b. In Fig. 6b, the subset 110a may comprise the nano-mechanical oscillator modules 100a; 100c, as described in the above figures, and the subset 110b may comprise the nano-mechanical oscillator modules 100b and 100d as described in the above figures. The at least one interface 12 is coupled to the control module 14 of the apparatus 10 and the composite signal is coupled to the antenna connector 320. In at least some embodiments, the composite signal 50 may be further filtered and/or amplified further for the antenna connector 320.

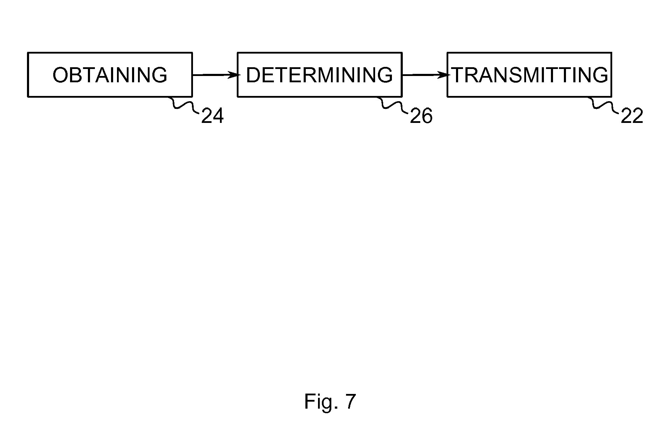

Fig. 7 illustrates a flow chart of an embodiment of a method suitable for controlling a contribution of a first plurality of continuously oscillating nano-mechanical oscillator modules 100a; 100b to a composite signal 50. The method comprises transmitting 22 a control signal and obtaining 24 information related to a plurality of frequency components of the composite signal. The method further comprises determining 26 the control signal based on the information related to the plurality of frequency components. The control signal controls the contribution of the first plurality 100a; 100b to the composite signal 50.

Some embodiments comprise a digital control circuit installed within the apparatus for performing the method. Such a digital control circuit, e.g. a Digital Signal Processor (DSP), needs to be programmed accordingly. Hence, yet further embodiments also provide a computer program having a program code for performing embodiments of the method, when the computer program is executed on a computer, a digital processor, or a programmable hardware component. A further embodiment is a computer readable storage medium storing instructions which, when executed by a computer, processor, or programmable hardware component, cause the computer to implement one of the methods described herein.

A person of skill in the art would readily recognize that steps of various above-described methods can be performed by programmed computers. Herein, some embodiments are also intended to cover program storage devices, e.g., digital data storage media, which are ma-chine or computer readable and encode machine-executable or computer-executable pro-grams of instructions where said instructions perform some or all of the steps of methods described herein. The program storage devices may be, e.g., digital memories, magnetic storage media such as magnetic disks and magnetic tapes, hard drives, or optically readable digital data storage media. The embodiments are also intended to cover computers programmed to perform said steps of methods described herein or (field) programmable logic arrays ((F)PLAs) or (field) programmable gate arrays ((F)PGAs), programmed to perform said steps of the above-described methods.

Embodiments may enable the HARP transmitter concept, which itself addresses future compact and energy efficient transmitters. Embodiments may simplify or enable control of the spectral contributions to the signal to be transmitted, which may comprise an elementary part of the HARP transmitter concept. Embodiments may further provide a reduction of power consumption in case of light load situations, by saving energy due to non-continuous oscillation of a certain number of sub-sub-arrays.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for ..." (performing a certain function) shall be understood as functional blocks comprising circuitry that is adapted for performing or to perform a certain function, respectively. Hence, a "means for s.th." may as well be understood as a "means being adapted or suited for s.th.". A means being adapted for performing a certain function does, hence, not imply that such means necessarily is performing said function (at a given time instant).

The functions of the various elements shown in the Figures, including any functional blocks labeled as "means", "means for controlling", "means for transmitting", "means for receiving", "means for transceiving", "means for processing", etc., may be provided through the use of dedicated hardware, such as "a controller", "a transmitter", "a receiver", "a transceiver", "a processor", etc. as well as hardware capable of executing software in association with appropriate software. Moreover, any entity described herein as "means", may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional or custom, may also be included. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

## Claims

1. Apparatus (10) suitable for controlling a contribution of a first plurality of continuously oscillating nano-mechanical oscillator modules (100a; 100b) to a composite signal (50), the apparatus (10) comprising
at least one interface (12) to transmit a control signal and to obtain information related to a plurality of frequency components of the composite signal; and
a control module (14) to determine the control signal based on the information related to the plurality of frequency components, wherein the control signal controls the contribution of the first plurality (100a; 100b) to the composite signal (50).

2. The apparatus (10) of claim 1, wherein the control module (14) is configured to control a plurality of switches (150a; 150b) between a plurality of resonator outputs (102a; 102b) of the first plurality (100a; 100b) and a shared power supply (200).

3. The apparatus (10) of claim 1, wherein the control module (14) is configured to control a plurality of power supplies (200a; 200b) for a plurality of resonator outputs (102a; 102b) of the first plurality (100a; 100b).

4. The apparatus (10) of claim 1 comprising the first plurality (100a; 100b), wherein a nano-mechanical oscillator module of the first plurality (100a; 100b) is configured to generate radio frequency signals at a specified oscillator frequency.

5. The apparatus (10) of claim 4 further comprising a second plurality of nano-mechanical oscillator modules (100c; 100d), wherein the apparatus (10) is further configured to control a contribution of the second plurality (100c; 100d) to the composite signal (50), and wherein the control module (14) is further configured to control the contribution of the second plurality (100c; 100d) to the composite signal (50) via the control signal.

6. The apparatus (10) of claim 5, wherein a nano-mechanical oscillator module of the second plurality (100c; 100d) is configured to generate radio frequency signals at a specified oscillator frequency.

7. The apparatus (10) of claim 6, further comprising a third plurality of subsets of nano-mechanical oscillator modules (110a; 110b), wherein a subset comprises one or more nano-mechanical oscillator modules generating radio frequency signals at the specified oscillator frequency.

8. The apparatus (10) of claim 7, wherein a subset of the third plurality (110a; 110b) comprises at least one continuously oscillating nano-mechanical oscillator module of the first plurality (100a; 100b).

9. The apparatus (10) of claim 8, wherein a subset of the third plurality further comprises at least one nano-mechanical oscillator module of the second plurality (100c; 100d).

10. The apparatus (10) of claim 9, wherein the at least one interface (12) is further configured to obtain information related to a power for the composite signal (50), and wherein the control module (14) is further configured to determine the control signal based on the information related to the power.

11. The apparatus (10) of claim 10, wherein the control module (14) is further configured to control an activation and/or deactivation of an excitation of the nano-mechanical oscillator modules of the second plurality (100c; 100d), and wherein the control module (14) is further configured to determine the control signal based on the information related to the power such that the excitation of the nano-mechanical oscillator modules of the second plurality (100c; 100d) is activated and/or deactivated based on the information related to the power.

12. A transmitter (300) comprising the apparatus (10) of claim 1 and the first plurality of continuously oscillating nano-mechanical oscillator modules (100a; 100b), wherein the composite signal (50) is provided to an antenna connector (320).

13. The transmitter (300) of claim 12 further comprising the features according to claim 11.

14. Method suitable for controlling a contribution of a first plurality of continuously oscillating nano-mechanical oscillator modules (100a; 100b) to a composite signal (50), the method comprising
transmitting (22) a control signal;
obtaining (24) information related to a plurality of frequency components of the composite signal; and
determining (26) the control signal based on the information related to the plurality of frequency components, wherein the control signal controls the contribution of the first plurality (100a; 100b) to the composite signal (50).

15. A computer program having a program code for performing the method of claim 14, when the computer program is executed on a computer, a processor, or a programmable hardware component.

## Amended claims

### Amended claims in accordance with Rule 137(2) EPC.

1. Apparatus (10) suitable for controlling a contribution of a first plurality of continuously oscillating nano-mechanical oscillator modules (100a; 100b) to a composite signal (50), the apparatus (10) comprising
at least one interface (12) to transmit a control signal and to obtain information related to a plurality of frequency components of the composite signal; and
a control module (14) to determine the control signal based on the information related to the plurality of frequency components, wherein the control signal is configured to control the contribution of the first plurality (100a; 100b) to the composite signal (50).

2. The apparatus (10) of claim 1, wherein the control module (14) is configured to control a plurality of switches (150a; 150b) between a plurality of resonator outputs (102a; 102b) of the first plurality (100a; 100b) and a shared power supply (200).

3. The apparatus (10) of claim 1, wherein the control module (14) is configured to control a plurality of power supplies (200a; 200b) for a plurality of resonator outputs (102a; 102b) of the first plurality (100a; 100b).

4. The apparatus (10) of claim 1 comprising the first plurality (100a; 100b), wherein a nano-mechanical oscillator module of the first plurality (100a; 100b) is configured to generate radio frequency signals at a specified oscillator frequency.

5. The apparatus (10) of claim 4 further comprising a second plurality of nano-mechanical oscillator modules (100c; 100d), wherein the apparatus (10) is further configured to control a contribution ofthe second plurality (100c; 100d) to the composite signal (50), and wherein the control module (14) is further configured to control the contribution of the second plurality (100c; 100d) to the composite signal (50) via the control signal.

6. The apparatus (10) of claim 5, wherein a nano-mechanical oscillator module of the second plurality (100c; 100d) is configured to generate radio frequency signals at a specified oscillator frequency.

7. The apparatus (10) of claim 6, further comprising a third plurality of subsets of nano-mechanical oscillator modules (110a; 110b), wherein a subset comprises one or more nano-mechanical oscillator modules generating radio frequency signals at the specified oscillator frequency.

8. The apparatus (10) of claim 7, wherein a subset of the third plurality (110a; 110b) comprises at least one continuously oscillating nano-mechanical oscillator module of the first plurality (100a; 100b).

9. The apparatus (10) of claim 8, wherein a subset of the third plurality further comprises at least one nano-mechanical oscillator module of the second plurality (100c; 100d).

10. The apparatus (10) of claim 9, wherein the at least one interface (12) is further configured to obtain information related to a power for the composite signal (50), and wherein the control module (14) is further configured to determine the control signal based on the information related to the power.

11. The apparatus (10) of claim 10, wherein the control module (14) is further configured to control an activation and/or deactivation of an excitation of the nano-mechanical oscillator modules ofthe second plurality (100c; 100d), and wherein the control module (14) is further configured to determine the control signal based on the information related to the power such that the excitation of the nano-mechanical oscillator modules of the second plurality (100c; 100d) is activated and/or deactivated based on the information related to the power.

12. A transmitter (300) comprising the apparatus (10) of claim 1 and the first plurality of continuously oscillating nano-mechanical oscillator modules (100a; 100b), wherein the composite signal (50) is provided to an antenna connector (320).

13. The transmitter (300) of claim 12 further comprising the features according to claim 11.

14. Method suitable for controlling a contribution of a first plurality of continuously oscillating nano-mechanical oscillator modules (100a; 100b) to a composite signal (50), the method comprising
transmitting (22) a control signal;
obtaining (24) information related to a plurality of frequency components of the composite signal; and
determining (26) the control signal based on the information related to the plurality of frequency components, wherein the control signal is configured to control the contribution ofthe first plurality (100a; 100b) to the composite signal (50).

15. A computer program having a program code for performing the method of claim 14, when the computer program is executed on a computer, a processor, or a programmable hardware component.
